(19) Europäisches Patentamt
European Patent Office
Office européen des brevets

(11) **EP 1 375 979 B1**

(12) **EUROPÄISCHE PATENTSCHRIFT**

(45) Veröffentlichungstag und Bekanntmachung des Hinweises auf die Patenterteilung:
**02.03.2011 Patentblatt 2011/09**

(51) Int Cl.:
*F16H 61/12* *(2010.01)*     *G01R 31/02* *(2006.01)*
*G05B 23/02* *(2006.01)*

(21) Anmeldenummer: **03014125.3**

(22) Anmeldetag: **24.06.2003**

(54) **Elektrisches Leistungsversorgungssystem und Diagnoseverfahren**

Electrical power supply system and diagnostic method

Système d'alimentation électrique et procédé de diagnostic

(84) Benannte Vertragsstaaten:
**AT BE BG CH CY CZ DE DK EE ES FI FR GB GR HU IE IT LI LU MC NL PT RO SE SI SK TR**

(30) Priorität: **28.06.2002 DE 10228983**

(43) Veröffentlichungstag der Anmeldung:
**02.01.2004 Patentblatt 2004/01**

(73) Patentinhaber: **Voith Turbo GmbH & Co. KG**
**89522 Heidenheim (DE)**

(72) Erfinder: **Dietzel, Bernd**
**89428 Syrgenstein (DE)**

(74) Vertreter: **Dr. Weitzel & Partner**
**Patentanwälte**
**Friedenstrasse 10**
**89522 Heidenheim (DE)**

(56) Entgegenhaltungen:
**DE-A- 3 939 630     DE-A- 4 112 996**
**DE-A- 4 242 177     DE-A- 19 745 175**
**US-A- 5 909 348**

**Beschreibung**

Die Erfindung betrifft ein elektrisches Leistungsversorgungssystem, ein Kennwertermittlungssystem sowie ein Diagnosesystem und -verfahren für ein elektrisches Leistungsversorgungssystem für Stelleinrichtungen in Antriebsaggregaten, insbesondere von elektromagnetischen Stelleinrichtungen in Getriebebaueinheiten.

Diagnoseverfahren und Vorrichtungen zur Erkennung von Fehlern bei der elektronischen Leistungsübertragung zu einer Getriebebaueinheit zugeordneten elektromagnetischen Stelleinrichtungen sind beispielsweise aus'den nachfolgend genannten Druckschriften bekannt:

    1. DE 197 45 175 A1
    2. DE 41 34 056 A1
    3. US 5 909 348 A

Die Druckschrift US 5 909 348 A beschreibt eine Schaltungsanordnung zur Erkennung eines Fehlerstroms oder Leckstroms auf einer Versorgungsleitung einer elektronischen Schaltung, Die Erkennung wird dabei mit Hilfe einer Hilfsspannungsquelle und mit einem Potentialmonitor zur Ermittlung und Auswertung des während einer Messphase auf der Versorgungsleitung herrschenden Potentials realisiert. Hierzu ist die Versorgungsleitung über eine Stromquelle, die für einen maximal zulässigen Fehlerstrom beziehungsweise Leckstrom ausgelegt ist, an die Hilfsspannungsquelle angeschlossen. Weiterhin sind elektromagnetische Stelleinrichtungen in Form von Spulen vorgesehen, weiche über eine gemeinsame Versorgungsleitung und über ein gemeinsames Relais an die Versorgungsspannung angeschlossen sind. Im Falle eines Vorliegens eines Fehlerstroms oder Leckstroms wird das Relais und damit die Stromversorgung aller Spulen gänzlich unterbrochen.

Die Druckschrift DE 197 45 175 A1 offenbart eine Diagnoseeinrichtung und ein Diagnoseverfahren für einem Automatgetriebe zugeordnete elektromagnetische Stelleinrichtungen. Die Stelleinrichtungen sind über eine gemeinsame Versorgungsleitung an eine Spannungsversorgung angeschlossen. In dieser ist ein Meßwiderstand mit einem Differenzverstärker zur Ermittelung des Summenstromes angeordnet, welcher mit dem Eingang einer Steuereinrichtung, insbesondere eines Microrechners gekoppelt ist. Des weiteren werden die, jeder Stelleinrichtung zugeführten Ströme einzeln ermittelt und deren Summe mit dem Summenstrom verglichen. Aus einer Abweichung kann ein Fehler erkannt werden, welcher zum Start eines Notprogrammes unter Sperrung bestimmter Gänge oder Überprüfung des fehlerhaften Strompfades und Kompensation der Abweichung durch Adaption der Ansteuerung eines Leistungsschalters führen kann.

Die Druckschrift DE 41 34 056 A1 offenbart eine Stromregelschaltung für ein elektromagnetisches Proportional-Stellglied. Eine speziell vorgesehene Kurzschluß-Sicherheitsschaltung schützt dabei die Stromregelschaltung gegen unbeabsichtigte Fehlanschlüsse sowie Leitungskurzschlüsse.

Ein Nachteil der bekannten Lösungen besteht darin, daß mit diesen eine Aussage über Fehler in der Leistungsübertragung entsprechend der konkreten Einbausituation nur auf der Basis einer Vielzahl aktueller Istwerte erfolgen kann, deren Ermittlung einen entsprechenden Aufwand voraussetzt. Eine separate Prüfung einzelner Leitungsverbindungen zu den Stelleinrichtungen ist mit der Ausführung entsprechend der erstgenannten Druckschrift nicht direkt möglich.

Der Erfindung liegt daher die Aufgabe zugrunde, ein Verfahren zur Diagnose und eine Diagnose- und Kennwertermittlungsvorrichtung zu schaffen, mittels welcher unabhängig von der Einbausituation von Spannungsversorgung und Stelleinrichtungen sehr einfach und mit geringem Aufwand eine objektive Aussage über die Leistungsversorgung einer einzelnen Stelleinrichtung, insbesondere deren Verkabelung und die an der Spannungsquelle erforderliche bereitzustellende Mindestspannung getroffen werden kann. Ferner sollten auch unzulässige Masseverbindungen sicher und schnell erkannt werden können.

Die erfindungsgemäße Lösung ist durch die Merkmale der Ansprüche 1, 2, 17 und 20 charakterisiert. Vorteilhafte Ausgestaltungen sind jeweils in den Unteransprüchen wiedergegeben.

Das erfindungsgemäße Diagnoseverfahren für die elektrische Leistungsversorgung von in Antriebsaggregaten, insbesondere Getrieben angeordneten elektromagnetischen Stelleinrichtungen erfolgt für erfindungsgemäße Schaltungsanordnungen elektrischer Leistungsversorgungssysteme mit einer Spannungsversorgung, jeweils einer, einer Stelleinrichtung zugeordneten Versorgungsleitung und einer allen Stelleinrichtungen gemeinsame Masserückleitung. Dabei sind die Stelleinrichtungen in räumlicher Entfernung zur Spannungsversorgung angeordnet. Die Steuerung der Stelleinrichtungen erfolgt über eine Steuereinrichtung. Diese dient der Beaufschlagung einer Stelleinrichtung über eine zugeordnete Versorgungsleitung, die mit einer räumlich entfernt angeordneten Spannungsversorgung gekoppelt ist. Allen Stelleinrichtungen ist eine gemeinsame Masserückleitung zugeordnet ist. Erfindungsgemäß wird in zeitlichem Abstand wenigstens der Spannungsabfall in der Masserückleitung ermittelt und es werden aus wenigstens dem Spannungsabfall in der Masserückleitung die Leitungswiderstände der einzelnen Versorgungsleitungen und der Masserückleitung ermittelt, wobei die bei einer Erstermittlung ermittelten Werte für die Leitungswiderstände in den Versorgungsleitungen und der Masserückleitung für Diagnosezwecke gemäß einer vorteilhaften Ausgestaltung als Referenzwerte gespeichert werden und jeweils mit den in zeitlichem Abstand ermittelten Werten für die Leitungswiderstände verglichen werden. Bei Überschreitung des Referenzwertes wird eine Fehlerinformation unter Berücksichtigung von Toleranzen abgeleitet.

Die Ermittlung des Spannungsabfalls in der Masserückleitung eines erfindungsgemäßen elektrischen Leistungsversorgungssystems beinhaltet die folgenden Schritte:

-    Bestromung wenigstens einer beliebigen ersten Stelleinrichtung bei gleichzeitiger Nicht-Bestromung einer weiteren zweiten, beliebigen Stelleinrichtung;
-    Messung des Spannungsabfalles zwischen der Versorgungsleitung der nicht bestromten Stelleinrichtung und der Masserückleitung.

Zur Ermittlung des Leitungswiderstandes in der Masserückleitung wird die Summe der Ströme zu den Stelleinrichtungen erfaßt. Diese entspricht dem Summenstrom in der Masserückleitung. Der Leitungswiderstand ergibt sich dann als Funktion aus Spannungsabfall zwischen der Versorgungsleitung der nicht bestromten Stelleinrichtung und der Masserückleitung und der Summe der Ströme in den einzelnen Versorgungsleitungen bzw. dem Summenstrom in der Masserückleitung. Der Spannungsabfall in einer bestromten Versorgungsleitung wird als Funktion des in dieser Versorgungsleitung fließenden Einzelstromes und des Widerstandes in der Masserückleitung bestimmt. Dazu wird bei Kenntnis des Leitungsquerschnittes der Masserückleitung aus dem Leitungswiderstand die Länge der Masserückleitung berechnet. Diese Länge der Masserückleitung wird unter eventueller Berücksichtigung eines Toleranzwertes der Länge der bestromten Versorgungsleitung gleichgesetzt, da beide Leitungen in der Regel in einem Kabelstrang verlegt werden. Bei bekanntem Leitungsquerschnitt der Versorgungsleitung wird der Leitungswiderstand der Versorgungsleitung berechnet. Aus dem Einzelstrom bzw. dem angenommenen Mindeststrom in der Versorgungsleitung und dem Leitungswiderstand wird der Spannungsabfall in der bestromten Versorgungsleitung berechnet.

Bei den Angaben bezüglich der Leitungsquerschnitte handelt es sich in der Regel um standardisierte Größen, welche bei Montage der Stelleinrichtungen der Schaltelemente und deren elektrischem Leistungsversorgungssystem in einer der Getriebebaueinheit zugeordneten Steuerung oder einer übergeordneten Steuereinrichtung abgelegt werden können oder ausgewählt werden können.

Das erfindungsgemäße Verfahren bietet den Vorteil, mit einer relativ einfachen Schaltungsanordnung unabhängig von der konkreten Einbausituation, insbesondere dem Abstand zwischen Stelleinrichtung und Spannungsversorgung sowie Erkennungs- und/oder Diagnoseeinrichtung mit geringem Aufwand auf die durch die Einbausituation bedingten Größen, insbesondere den Leitungswiderstand und die verwendete Leitungslänge zu schließen und diese als Grundlage für die Fehlererkennung zu nutzen, da aus einer starken Veränderung des Widerstandswertes auf einen Fehler geschlossen werden kann, insbesondere einen Defekt in der Verkabelung. Des weiteren kann dieses Verfahren bei Erstinbetriebnahme in vorteilhafter Weise der Überprüfung auf Funktionsfähigkeit dienen.

In besonders vorteilhafter Weise ist in der Masserückleitung mindestens ein Schalter vorgesehen, der derart gestaltet ist, dass über diesen im geöffneten Zustand und bei Bestromung der Stelleinrichtungen bei Fließen eines Stromes eine unzulässige Masseverbindung mit beispielsweise einem Gehäuse oder einem anderen Element oder der Fahrzeugmasse erkennbar ist. Dazu wird bei geöffnetem Schalter $S_1$ versucht, einen Strom durch eine der Stelleinrichtungen zu schicken. Dabei kann nur dann ein Strom fließen, wenn eine unzulässige Masseverbindung vorhanden ist. Bei dem Schalter kann es sich beispielsweise um einen Halbleiterschalter oder ein Relais handeln. Der Schalter kann in der Steuerrichtung des Kennwertermittlungssystems oder außerhalb angeordnet sein.

Unter einem weiteren Aspekt der Erfindung kann das erfindungsgemäße Verfahren unter Berücksichtung aller gleichzeitig betätigten Stelleinrichtungen zur Ermittlung der erforderlichen Summenspannung aus dem Abfall über der Masserückleitung herangezogen werden. Die Mindestbetätigungsspannung, welche für eine Stelleinrichtung bereitzustellen ist, ergibt sich aus dem Spannungsabfall über der dieser zugeordneten Versorgungsleitung bei Mindeststrom, der Mindestfunktionsspannung der Stelleinrichtung, d.h. dem Spannungsabfall über der Stelleinrichtung, und dem Spannungsabfall über der Masserückleitung. Letzterer ist dabei von der Anzahl der gleichzeitig betätigten Stelleinrichtungen abhängig. Diese Bestimmung kann insbesondere bei Erstinbetriebnahme der Festsetzung oder Überprüfung der von den Herstellern für die Einzelaggregate geforderten Mindestfunktionsspannungen dienen, welche für die Funktion der einzelnen Stelleinrichtung erforderlich sind.

Unter einem weiteren Aspekt der Erfindung kann bei Abweichung der jeweiligen Leitungswiderstandswerte vom Referenzwert auf die Art des Fehlers geschlossen werden und die Fehlerinformation in Abhängigkeit von der Größe der Abweichung erzeugt werden. So kann bei geringen Abweichungen lediglich eine Fehlerinformation - optisch oder akustisch bei gleichzeitigem weiteren Betrieb erfolgen, während bei großen Abweichungen neben der Information auch eine Sperrung der Gangstufen erfolgen kann, die durch die Betätigung der Stelleinrichtungen beschrieben sind, bei deren Versorgungsleitungen erhöhte Widerstandswerte ermittelt werden. Dies bietet den Vorteil, daß evt. nicht absehbare Schädigungen aufgrund des widerstandserhöhenden Defekts vermieden werden können.

Die Erfassung der Werte in zeitlichem Abstand erfolgt

a) in fest vorgegebenen oder
b) frei wählbaren oder
c) vordefinierbaren Zeitintervallen oder

d) beliebig auf Wunsch.

Um eine möglichst objektive Fehlerinformation zu erhalten, werden die nach Erstinbetriebnahme ermittelten Leitungswiderstände vor dem Vergleich mit dem Referenzwert immer um einen Korrekturwert, welcher das Widerstandsverhalten bei unterschiedlichen Temperaturen wiederspiegelt, korrigiert. Der Korrekturwert kann dabei unter Berücksichtigung wenigstens einer, die aktuelle Temperatur wenigstens mittelbar beschreibenden Größe in der Umgebung der Leitungen berechnet werden oder wird lediglich geschätzt. Im letzgenannten Fall kann auch ein Korrekturwert vorgegeben werden, welcher einen möglichen Bereich begrenzen soll.

Das vorgesehene Diagnosesystem für ein elektrisches Leistungsversorgungssystem für Stelleinrichtungen in Antriebsaggregaten, insbesondere elektromagnetisch betätigbarer Stellglieder einer Getriebebaueinheit umfaßt ein Kennwertermittlungssystem. Dieses umfaßt eine Schaltungsanordnung mit einer Spannungsversorgungsquelle, eine, jeder elektromagnetischen Stelleinrichtung zugeordnete Versorgungsleitung, die mit der Spannungsversorgungsquelle gekoppelt ist und eine, allen elektromagnetischen Stelleinrichtungen gemeinsam zugeordnete Masserückleitung und eine Kennwertermittlungs- beziehungsweise Bestimmungseinrichtung, welche gleichzeitig die Diagnoseeinrichtung bildet, und wenigstens einen Microcontroller umfaßt. Jede Versorgungsleitung ist mit einem eigenen Eingang der Kennwertermittlungs- beziehungsweise Bestimmungseinrichtung gekoppelt. Es sind Mittel zur Erfassung des Spannungsabfalles zwischen jeweils einer Versorgungsleitung und der Masserückleitung vorgesehen. Diese Mittel bilden die Eingänge der Kennwertermittlungs- beziehungsweise Bestimmungseinrichtung. Des weiteren sind Mittel zur Erfassung des Stromes in jeder Versorgungsleitung vorgesehen. Zur Verarbeitung der einzelnen Größen ist wenigstens eine Berechnungs- und Zuordnungseinrichtung zur Ermittlung der nachfolgend genannten Größen vorgesehen:

- Summe der Ströme zu den bestromten Stelleinrichtungen;
- Spannungsabfall in der Masserückleitung;
- Leitungswiderstand in der Masserückleitung;
- Länge der Masserückleitung;
- Leitungswiderstand und Spannungsabfall in der Versorgungsleitung. Bei Integration des Kennwertermittlungssystems in einem Diagnosesystem umfaßt dieses einen Speicher zur Speicherung von Referenzwerten und eine Vergleichseinrichtung zum Vergleich aktuell ermittelter Größen mit Referenzwerten. Mit der Vergleichseinrichtung ist ein Stellgrößenbildner für eine Fehlerinformation gekoppelt. Die Funktion des Speichers, der Berechnungs- und Zuordnungseinrichtungen und der Vergleichseinrichtung werden vorzugsweise vom Microcontroller übernommen, so daß diese nicht als separate bauliche Einheiten vorliegen. Der Microcontroller ist in diesem Fall mit den entsprechenden Eingängen der Diagnoseeinrichtung gekoppelt bzw. bildet diese. Gemäß einer besonders vorteilhaften Ausgestaltung in einem Steuer- und Regelsystem für Getriebebaueinheiten werden die Kennwerterfassungseinrichtung und Diagnoseeinrichtung vom Getriebesteuergerät bzw. dem Gerät eines diesem übergeordneten Steuersystems gebildet, d.h. die Funktion der Diagnose wird von einem ohnehin vorhandenen System mit übernommen.

Die erfindungsgemäße Lösung wird nachfolgend anhand von Figuren erläutert. Darin ist im einzelnen folgendes dargestellt:

Figur 1    verdeutlicht in schematisch vereinfachter Darstellung den Grundaufbau eines erfindungsgemäß gestalteten Diagnosesystems;

Figur 2    verdeutlicht anhand eines Signalflußbildes den Ablauf des erfindungsgemäßen Verfahrens.

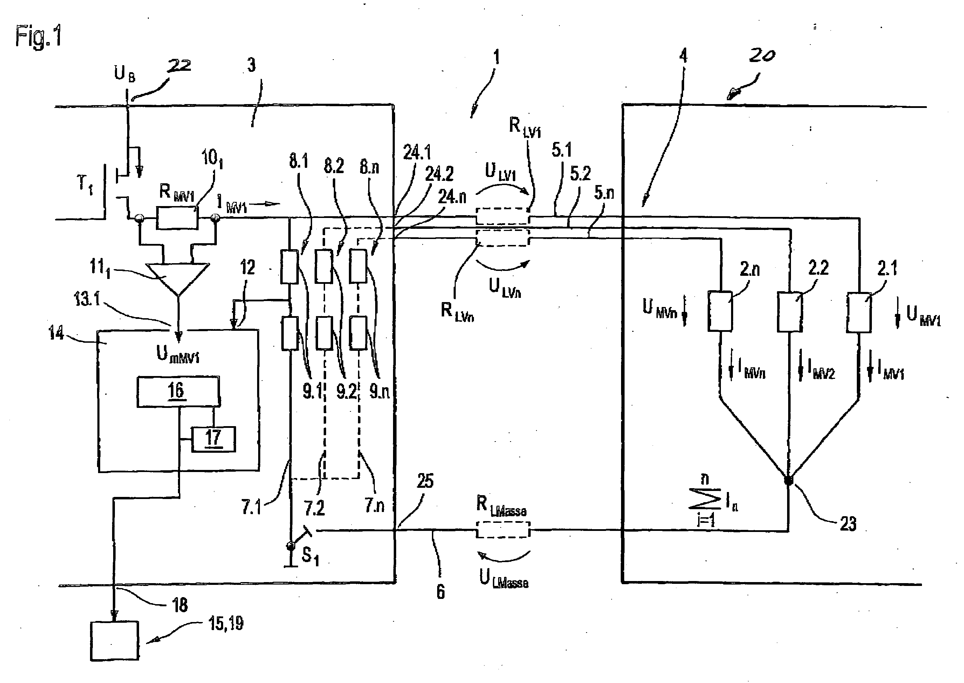

Die Figur 1 verdeutlicht in schematisch vereinfachter Darstellung den Grundaufbau einer erfindungsgemäß gestalteten Diagnose- und/oder Kennwertermittlungsvorrichtung 1 für die elektrische Leistungsversorgung elektromagnetischer Stelleinrichtungen 2.1 bis 2.n, im dargestellten Fall 2.1, 2.2 und 2.n, beispielsweise in Form von Magnetspulen als elektromagnetische Aktuatoren zur Realisierung eines Gangstufenwechsels in einer Getriebebaueinheit. Zur Ansteuerung bzw. Beeinflussung der Betriebsweise dieser elektromagnetischen Stelleinrichtungen 2.1 bis 2.n werden diese mittels einer zugeordneten Steuereinrichtung 3, umfassend wenigstens einen Microrechner je nach gewünschter einzulegender Gangstufe bestromt. Die Schaltungsanordnung 4 zur Koppelung der einzelnen Stelleinrichtungen 2.1 bis 2.n mit einer dafür vorgesehenen Spannungsversorgungsquelle 22 gestaltet sich wie folgt: Die einzelnen elektromagnetischen Stelleinrichtungen 2.1 bis 2.n sind über eine, jeder Stelleinrichtung 2.1 bis 2.n zugeordnete Versorgungsleitung 5.1 bis 5.n mit einer Spannungsversorgung 22 zur Bereitstellung der Versorgungsspannung $U_B$ über $T_1$ bis $T_n$ verbindbar, wobei aus Übersichtlichkeitsgründen lediglich T1 dargestellt ist. Die Steuereinrichtung 3 ist in der Regel als Steuergerät ausgeführt und in räumlicher Entfernung zur Getriebebaueinheit angeordnet. Jeder elektromagnetischen Stelleinrichtung 2.1 bis 2.n ist eine eigene Versorgungsleitung 5.1 bis 5.3 zugeordnet. Die Steuereinrichtung 3 umfaßt dazu jeweils n Ausgänge 24.1 bis 24.n, welche über die Versorgungsleitungen 5.1 bis 5.n mit den Stelleinrichtungen 2.1 bis 2.n gekoppelt sind. Die elektromagnetischen Stelleinrichtungen 2.1 bis 2.3 weisen jedoch eine gemeinsame Masserückleitung 6 auf, welche mit einem Eingang 25 gekoppelt ist. Dazu werden die einzelnen Versorgungsleitungen 5.1 bis 5.n der Stelleinrichtungen 2.1 bis 2.n in Stromflußrichtung hinter den Stelleinrichtungen 2.1 bis 2.n in einem Knoten 23 zusammengeführt, an welchem die Masserückleitung 6 im Getriebe gekoppelt ist. Jede Versorgungsleitung 5.1 bis 5.n ist mit der Masserückleitung 6 in unmittelbarer räumlicher Nähe zum elektronischen Steuergerät 3 oder vorzugsweise in diesem über eine Verbindungsleitung 7.1 bis 7.n gekoppelt - hier nur 7.1 dargestellt - in welcher jeweils Mittel 8.1 bis 8.n zur Erfassung wenigstens einer, den Spannungsabfall $U_n$ zwischen der Versorgungsleitung 5.n und der Masserückleitung 6 wenigstens indirekt charakterisierenden Größe angeordnet sind. Diese Mittel werden in der Regel von Meßwiderständen 9 gebildet, über die bei Kenntnis des jeweils über die entsprechende elektromagnetische Stelleinrichtung 2.1, 2.2 oder 2.n fließenden Stromes $I_{MV1}$, $I_{MV2}$ oder $I_{MVn}$ der Spannungsabfall $U_1$, $U_2$ oder $U_n$ ermittelt werden kann. Jede Versorgungsleitung 5.1 bis 5.n enthält ferner einen Meßwiderstand $10_{1-n}$ mit einem, diesem zugeordneten Differenzverstärker $11_{1-n}$ zur Ermittlung des Stromes $I_{MVn}$. In der Figur 1 sind zur Verdeutlichung aus Übersichtlichkeitsgründen lediglich der Meßwiderstand und Differenzverstärker für die erste Versorgungsleitung 5.1 dargestellt.

Der Spannungsabfall $U_1$ - $U_3$ bzw. $U_n$ mittels des Spannungsteilers 8.1/9.1 stellt dabei nicht die tatsächlich an den elektromagnetischen Stelleinrichtungen 2.n wirksame Spannung dar, sondern enthält zusätzlich den Spannungsabfall über der Masserückleitung 6 $U_{LMasse}$ und den Spannungsabfall über der Stelleinrichtung 2.n zugeordneten Versorgungsleitung 5.n $U_{LVn}$, hier beispielsweise $U_{LV1}$ der Versorgungsleitung 5.1. Der Spannungsabfall $U_{LMasse}$ in der Masserückleitung 6 ergibt sich dabei aus dem Produkt der Summe der Ströme $I_{MV1}$ bis $I_{MVn}$ durch die elektromagnetischen Stelleinrichtungen 2.1 bis 2.n und dem Leitungswiderstand $R_{LMasse}$. Der Spannungsabfall $U_n$ zwischen der entsprechenden

Versorgungsleitung 5.1 bis 5.n und der Masserückleitung 6 ergibt sich nach folgender Beziehung:

$$(1) \qquad U_n = U_{MVn} + U_{LVn} + U_{LMasse}$$

mit

| | |
|---|---|
| $U_n$ - | Spannungsabfall zwischen Versorgungsleitung 5.n und Masserückleitung 6 bzw. Ausgang 24.n und Eingang 6 |
| $U_{MVn}$ | Spannungsabfall über der elektromagnetischen Stelleinrichtung 2.n |
| $U_{LVn}$ | Spannungsabfall in der Versorgungsleitung 5.n zur Versorgung des elektromagnetischen Stellgliedes 2.n |
| $U_{LMasse}$ - | Spannungsabfall in der Masserückleitung 6. |

Für den sicheren Betrieb der elektromagnetischen Stellglieder 2.1 bis 2.n ist ein definierter Mindeststrom und/oder eine definierte Mindestfunktionsspannung erforderlich bzw. eine aus dem Mindeststrom unter angenommenen Extrembedingungen sich ergebende minimale Betriebsspannung $U_{MVn}$ an den elektromagnetischen Stellgliedern 2.n. Dabei ist es bekannt, daß die Versorgungsspannung $U_B$ beim Einsatz in Fahrzeugen aufgrund der Belastung des Bordnetzes stark schwanken kann. Von den Fahrzeugherstellern sind somit bestimmte Minimalspannungen $U_{B-mindest}$ angegeben, bis zu welchen die einzelnen Steuereinrichtungen und Aktuatoren, d.h. das Steuergerät 3 und elektromagnetische Stelleinrichtungen 2.1 bis 2.n, ihre Funktion gewährleisten müssen. Aufgrund unterschiedlicher Einbausituationen in den Fahrzeugen und die dadurch oft bedingten unterschiedlichen Längen der Versorgungsleitungen 5.1 bis 5.n zwischen den Stelleinrichtungen 2.1 bis 2.n der Getriebebaueinheit und der der Getriebebaueinheit zugeordneten Steuereinrichtung ergeben sich somit verschiedene Mindestwerte für die an der Steuereinrichtung 3 erforderliche Betriebsspannung $U_{B-mindest}$. Um die erforderliche Mindestspannung $U_{B-mindest}$ für eine bestimmte Einbausituation zu definieren, ist es erforderlich, den Spannungsabfall über den Versorgungsleitungen 5.1 bis 5.n und der Masserückleitung 6 zu bestimmen. Dies erfolgt bei Inbetriebnahme des

Fahrzeuges, wobei überprüft wird, ob ein Bereich für die Mindestspannung bereits vorgegeben ist. Ist diese nicht vorgegeben, wird die erforderliche Mindestspannung als Funktion der Spannungsabfälle über den Versorgungsleitungen 5.1 bis 5.n, den Stelleinrichtungen 2.1 bis 2.n und der Masserückleitung 6 bestimmt.

Dazu ist es zuerst einmal erforderlich, den Spannungsabfall über einer der Leitungen zu bestimmen. Dazu wird erfindungsgemäß zuerst der Spannungsabfall $U_{LMasse}$ in der Masserückleitung 6 bestimmt. Zur Bestimmung dessen wird in einem ersten Verfahrensschritt bei der beschriebenen Schaltungsanordnung 4 wenigstens eine erste elektromagnetische Stelleinrichtung, beispielsweise 2.1, nicht bestromt, während wenigstens eine weitere zweite oder auch mehrere Stelleinrichtungen, hier beispielsweise 2.2 und 2.n, bestromt werden. Entsprechend dem Maschensatz ergibt sich aus der obengenannten Beziehung für den Spannungsabfall $U_1$ zwischen der Versorgungsleitung 5.1 und der Masserückleitung 6 aufgrund der Nichtbestromung folgende Beziehung $U_1 = U_{LMasse}$.

Diese Größe wird einem Eingang 12 des $\mu$C am elektronischen Steuergerät 3 zugeführt (bei Integration der Meßwiderstände 9 bzw. dieses Teiles der Schaltungsanordnung 4 im Steuergerät 3). Zur Bestimmung der Länge I der Masserückleitung 6 wird der Leitungswiderstand $R_{LMasse}$ aus der Beziehung $R_{LMasse} = U_{LMasse}/I_{Summe}$ ermittelt, wobei entsprechend dem Knotensatz $I_{Summe}$ sich aus folgender Erziehung ergibt

$$I_{Summe} = I_{MV1} + \ldots + I_{MVn}$$

mit

$I_{MVn}$ -   Strom über das elektromagnetische Stellglied 2.n.

Die Summe der Ströme wird weiteren Eingängen 13.1 ...13.n zugeführt. In einer Berechnungseinheit 14 erfolgt die Bestimmung des Leitungswiderstandes $R_{LMasse}$ in der Masserückleitung aus der Beziehung

$$R_{LMasse} = U_{LMasse}/I_{Summe}.$$

Bei Kenntnis des Leiterquerschnittes A der Masserückleitung 6 kann dann die Länge $l_{Masse}$ als Funktion des Querschnittes A berechnet werden. Zu diesem Zweck kann die Information zum Leiterquerschnitt A entweder bereits in der Steuereinrichtung 3 hinterlegt sein oder ist aus einer anderen Datenquelle abrufbar oder kann eingegeben werden.

Die Berechnung kann auch in einer zu diesem Zweck angeschlossenen Diagnosesystemeinrichtung (PC ...) erfolgen.

Aufgrund der in einem gemeinsamen Kabelstrang erfolgenden Anordnung von Versorgungsleitung 5.1 bis 5.n und Masserückleitung 6 kann bei bekanntem Leitungsquerschnitt A der Versorgungsleitungen der Leitungswiderstand $R_{LVn}$ und der Spannungsabfall über der Versorgungsleitung $U_{LVn}$ berechnet werden. Aus den Aussagen über die Länge der einzelnen Leitungen - Versorgungsleitung 5.1 bis 5.n bzw. Masserückleitung 6 kann der Funktionsbereich der Getriebesteuerung mitsamt der einzelnen Aktuatoren, d.h. elektromagnetischen Stelleinrichtungen 2.1 bis 2.n, in bezug auf die an der Spannungsquelle 22 bereitzustellende Betriebsspannung $U_{B-mindest}$ angegeben werden. Diese Informationen, zumindest über die einzelnen Widerstände - Leitungswiderstand $R_{LMasse}$ und $R_{LVn}$ -, werden bei Inbetriebnahmen oder Erstabnahmen beim Einsatz in Fahrzeugen zur Kontrolle der Funktion des Gesamtsystems und dessen Zuverlässigkeit ermittelt. Diese Information wird dabei vorzugsweise über eine Anzeigevorrichtung 15 ausgegeben und wird des weiteren in einer Speichereinheit 16 hinterlegt.

Zu Diagnosezwecken werden in bestimmten Zeitabständen $\Delta t$, welche entweder vorgegebene feste Zeitintervalle beschreiben, frei wählbar sind oder beliebig festsetzbar sind, die Widerstände $R_{LMasse}$ und $R_{LVn}$ in der Masserückleitung 6 und der Versorgungsleitung 5.1 bis 5.n ermittelt. Die Ermittlung erfolgt wie bereits beschrieben, wobei diese mit den anfänglich ermittelten Werten verglichen werden, beispielsweise in einer Vergleichseinrichtung 17, so daß Abweichungen erkannt werden können. Da die Messungen in der Regel während des Betriebes erfolgen und die Widerstandswerte temperaturabhängig sind, werden die zu einem Zeitpunkt $\Delta t$ ermittelten Widerstandswerte $R_{LMasse}$ und $R_{LVn}$ hinsichtlich der Temperaturabhängigkeit angepaßt, entweder durch konkrete Erfassung der Temperatur, wobei in diesem Fall eine Einrichtung zur Erfassung der Temperaturen der entsprechenden Leitungen - Masserückleitung 6 oder Versorgungsleitung 5.1 bis 5.n - vorgesehen ist oder es wird ein Korrekturwert, beispielsweise in Form eines Skalierungsfaktors abgeschätzt oder ein Toleranzband angenommen. Ist trotzdem beim Vergleich eine sehr starke Erhöhung des gemessenen Leitungswiderstandes für die Masserückleitung 6 und/oder die einzelnen Versorgungsleitungen 5.1 bis 5.n ermittelt, kann aus diesem Vergleichsergebnis auf einen Fehler geschlossen werden, beispielsweise auf erhöhte Übergangswiderstände im Bereich von Steckverbindungen. Dabei kann entweder eine Fehlermeldung an einem Ausgang 18 ausgegeben werden, welche über ein Display 19 anzeigbar ist, oder aber in anderer Art und Weise ein für den Fahrer erkennbares Signal für eine im Bereich der Leitungsverbindung liegende Fehlerquelle schließen läßt. Für die weitere Betriebsweise bestehen folgende Möglichkeiten:

-   Anzeige mit Hinweis auf Defekt und Aufforderung Werkstatt aufzusuchen
-   Anzeige und Sperrung der Gangstufen, die durch die Betätigung der Stelleinrichtungen charakterisiert sind, für welche erhöhte Widerstandswerte ermittelt wurden

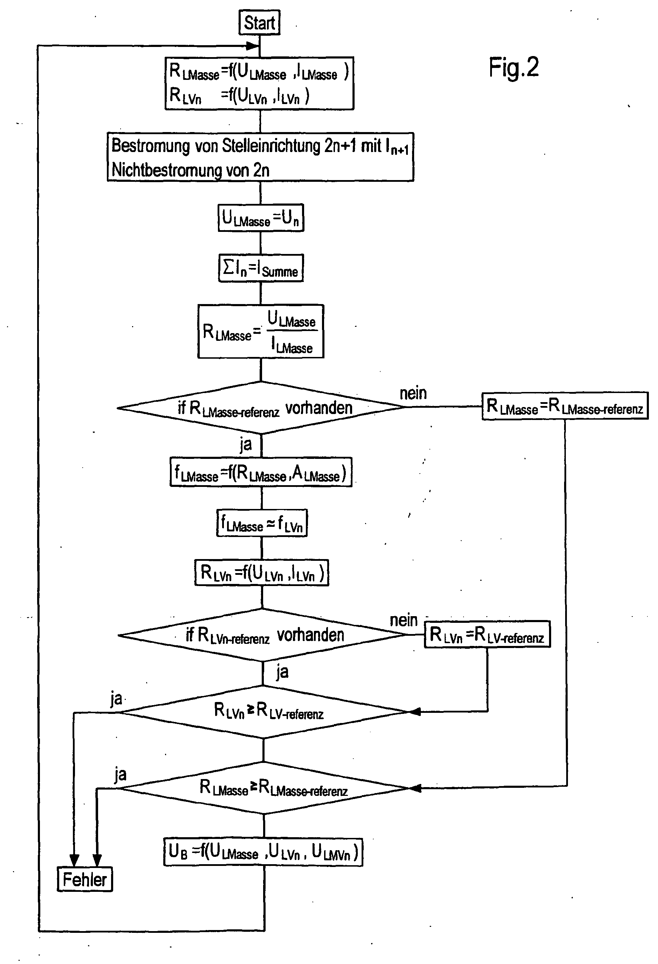

Das erfindungsgemäße Diagnoseverfahren gestaltet sich dabei wie in Figur 2 anhand eines Signalflußbildes verdeutlicht. Bei Erstinbetriebnahme oder Inbetriebnahme des Fahrzeuges wird bei einer Schaltungsanordnung 4 gemäß Figur 1 eines der elektromagnetischen Stellglieder 2.1 bis 2.n, beispielsweise 2.1, frei von einer Bestromung gehalten, während wenigstens ein anders der, vorzugsweise mehrere der elektromagnetischen Stellglieder 2.2 bis 2.n mit einem Strom $I_{MV2}$ bis $I_{MVN}$ beschickt werden. Dabei wird der Spannungsabfall $U_1$ zwischen der Versorgungsleitung 2.1 und der Masserückleitung 6 ermittelt. Dieser entspricht aufgrund der Nichtbestromung dem Spannungsabfall $U_{LMasse}$ in der Masserückleitung 6. In einem weiteren Verfahrensschritt wird gleichzeitig oder auch zeitlich versetzt der Summenstrom $I_{Summe}$ aus der Summe der zu den einzelnen Stelleinrichtungen 2.1 bis 2.n fließenden Ströme $I_{MV1}$ bis $I_{MVn}$ ermittelt. Aus diesen Größen wird der Leitungswiderstand $R_{LMasse}$ aus dem Quotienten $U_{LMasse}$ und dem Summenstrom $I_{Summe}$ ermittelt. Unter Berücksichtigung des Leiterquerschnittes der Masserückleitung 6 erfolgt die Ermittlung der Länge $l_{Masse}$ als Funktion des Querschnittes $A_{Masse}$ der Masserückleitung 6. Unter Berücksichtigung, daß die Länge der Masserückleitung 6

$I_{Masse}$ in etwa, also rund der Länge der Versorgungsleitung $I_{V1}$ entspricht, da beide Leitungen in der Regel in einem Kabelstrang geführt werden, kann der Widerstand in der Zulaufleitung $R_{LV1}$ als Funktion der Länge $I_{V1}$ und des Querschnittes $A_{V1}$ ermittelt werden. Erfindungsgemäß werden die ermittelten Widerstandswerte für die Masserückleitung 6 und die einzelnen Versorgungsleitungen 5.1 bis 5.n in bestimmten Zeitintervallen erneut ermittelt und mit den bei erstmaliger Ermittlung festgelegten Werten verglichen. Diese werden dazu als Vergleichsgröße in einer Speichereinrichtung hinterlegt oder beispielsweise auch über ein Datenkommunikationsnetzwerk auf anderen Informationsträgern. Die jeweils neu ermittelten Widerstandswerte werden im Hinblick auf die Temperaturabhängigkeit angepaßt, d.h. entweder mit einem entsprechenden Faktor multipliziert oder einer anderen mathematischen Operation unterzogen.

Ergibt der Vergleich eine starke Änderung des Widerstandswertes oder aber eine über einen bestimmten Toleranzbereich erfolgende Erhöhung, wird für die jeweilige Leitung bzw. deren Verbindungen ein Fehler diagnostiziert und kann beispielsweise in Form eines optisch erkennbaren Signales, ausgegeben werden. Der Fahrer kann dann entscheiden, ob er den Fahrvorgang unterbricht oder nicht. Im anderen Fall kann bereits ohne Zutun des Fahrers die Gangstufe, welche durch die Betätigung der entsprechenden Stelleinrichtungen charakterisiert ist, gesperrt werden.

Über die entsprechende Bestromung - angenommene Mindestbestromung für Stelleinrichtung 2.1 kann des weiteren der Spannungsabfall $U_{LV1}$ als Funktion des Stromes $I_{MV1}$ und $R_{LV1}$ ermittelt werden. Aus den einzelnen Größen des Spannungsabfalles in der Masserückleitung 6 und der Versorgungsleitung 5.1 bis 5.n kann dabei unter Berücksichtigung der erforderlichen Bestromungen für die Funktion der einzelnen gleichzeitig miteinander zu betätigenden Stelleinrichtungen auf die erforderliche an der Spannungsquelle 22 bereitzustellende Mindestspannung $U_{B-mindest} = f(U_{Ln}, U_{LMasse}, U_{MVn})$ geschlossen werden. Diese bis zur Ermittlung der Mindestspannung $U_{B-mindest}$ vorgenommenen Verfahrensschritte können dabei zum einen in ein Verfahren zur Bereitstellung einer Mindestspannung $U_{B-mindest}$ und Verhinderung von deren Unterschreitung integriert werden, wobei dieser Mindestspannungswert $U_{B-mindest}$ vorzugsweise bei Inbetriebnahme bzw. Erstinbetriebnahme des Fahrzeuges ermittelt und in einem Speicher hinterlegt wird. Dabei wird die aktuell mögliche anliegende Versorgungsspannung $U_{B-aktuell}$ in einem Bordnetz fortlaufend mit der Mindestspannung $U_{B-mindest}$ verglichen, wobei bei Überschreitung keine Reaktion erfolgt, während bei Unterschreitung eine Stellgröße zur Bereitstellung der erforderlichen Mindestspannung $U_{B-mindest}$ abgegeben wird, was beispielsweise durch Ansteuerung einer Energiequelle oder aber Abschaltung von anderen Verbrauchern erfolgen kann.

Gemäß einer besonders vorteilhaften Weiterentwicklung besteht zusätzlich die Möglichkeit in der in der Figur 1 beschriebenen Schaltungsanordnung zwischen der Masserückleitung 6 und der Verbindungsleitung zwischen Versorgungsleitung und Masserückleitung einen Schalter $S_1$ vorzusehen, womit eine Überprüfung hinsichtlich einer unzulässigen Masseverbindung erfolgen kann, indem bei geöffnetem Schalter $S_1$ ein Strom über eines der Stellglieder 2.1 bis 2.n geschickt wird. Lediglich bei einer unzulässigen Masseverbindung wird ein Strom fließen, ansonsten kann kein Strom ermittelt werden.

Die Gesamtheit aus Spannungsquelle 22, Versorgungsleitungen und Masserückleitung bildet ein elektrisches Leistungsversorgungssystem 25; dieses kombiniert mit dem Steuergerät ohne Speichereinrichtung und Vergleichseinrichtung für frühere Werte bildet das Diagnosesystem. Zur Kennwertermittlung sind ein Speicher und eine Vergleichseinrichtung nicht zwingend erforderlich.

Bezugszeichenliste

| | |
|---|---|
| 1 | Diagnosesystem |
| 2.1 - 2.n | elektromagnetische Stelleinrichtungen |
| 3 | elektronisches Steuergerät |
| 4 | Schaltungsanordnung |
| 5.1 - 5.n | Versorgungsleitung |
| 6 | Masserückleitung |
| 7.1 - 7.3 | Verbindungsleitung |
| 8 | Mittel zur wenigstens mittelbaren Erfassung wenigstens einer den Spannungsabfall wenigstens indirekt charakterisierenden Größe |
| 9 | Meßwiderstand |
| 10 | Meßwiderstand |
| 11 | Differenzverstärker |
| 12 | Eingang |
| 13 | Eingang |
| 14 | Berechnungseinheit |
| 15 | Anzeigevorrichtung |
| 16 | Speichereinheit |
| 17 | Vergleichseinrichtung |
| 18 | Ausgang |
| 19 | Display |
| 22 | Spannungsversorgungsquelle |
| 23 | Knoten |
| 24.1 - 24.n | Ausgang |
| 25 | Leistungsversorgungssystem |
| $U_B$ | Versorgungsspannung |
| $U_{Bmindest}$ | Mindestversorgungsspannung |
| $I_1$ bis $I_n$ | Ströme zu den elektromagnetischen Stellgliedern 2.1 bis 2.n |
| $U_1$ bis $U_n$ | Spannungsabfall zwischen der Versorgungsleitung 24.1 bis 24.n und der Masserückleitung 6 |

$U_{LMasse}$ Spannungsabfall über der Masserückleitung

$U_{Ln}$ Spannungsabfall über der Versorgungsleitung n

$U_{MVn}$ Spannungsabfall am elektromagnetischen Stellglied n

$R_{LMasse}$ Leitungswiderstand der Masserückleitung

$R_{Ln}$ Leitungswiderstand der Versorgungsleitung

$A_{Masse}$ Leiterquerschnitt der Masserückleitung

$A_{Ln}$ Leitungsquerschnitt der Versorgungsleitung n

$I_{Masse}$ Länge der Masserückleitung (6)

$I_{Ln}$ Länge der Versorgungsleitung

**Patentansprüche**

1. Elektrisches Leistungsversorgungssystem (25) für Stelleinrichtungen (2.1-2.n) in Antriebsaggregaten, insbesondere elektromagnetisch betätigbarer Stellglieder einer Getriebebaueinheit;
   mit einer Schaltungsanordnung (4),
   die Schaltungsanordnung (4) umfassend eine Spannungsversorgungsquelle (22); die Schaltungsanordnung (4) umfassend eine jeder elektromagnetischen Stelleinrichtung (2.1-2,n) zugeordnete Versorgungsleitung (5.1-5.n), die mit der Spannungsversorgungsquelle (22) verbindbar ist;
   mit Mitteln zur Erfassung des Stromes in jeder Versorgungsleitung (5.1-5,n);
   **gekennzeichnet durch** die folgenden Merkmale:

   eine allen elektromagnetischen Stelleinrichtungen (2.1-2.n) gemeinsam zugeordnete Masserückleitung (6);
   Mittel zur Erfassung des Spannungsabfalles zwischen jeweils einer Versorgungsleitung (5.1-5,n) und der gemeinsamen Masserückleitung (6);
   ein Kennwertermittlungssystem, umfassend eine Kennwertermittlungs- und Bestimmungseinrichtung und wenigstens einen Microcontroller;
   wenigstens eine Berechnungs- und Zuordnungseinrichtung (14) zur Ermittlung der nachfolgend genannten Größen:

   - Summe der Ströme zu den bestromten Stelleinrichtungen (2,1-2,n);
   - Spannungsabfall in der Masserückieltung (6);
   - Leitungswiderstand der Masserückleitung (6);
   - Länge der Masserückleitung (6);
   - Leitungswiderstand und Spannungsabfall in der Versorgungsleitung 5.1-5.n); und

ein in der gemeinsamen Masserückleitung (6) angeordneter Schalter ($S_1$), der derart ausgebildet ist, dass über diesen bei Öffnung des Schalters und gleichzeitiger Bestromung wenigstens einer ersten Stelleinrichtung (2.1-2.n) und gleichzeitiger Nicht-Bestromung wenigstens einer zweiten Stellelnrichtung (2.1-2.n) ein Fließen eines Stromes oder ein Spannungsabfall zwischen der Versorgungsleitung (5.1-5.n) der nicht bestromten Stelleinrichtung (2.1-2,n) und der gemeinsamen Masserückleitung (6) erkennbar ist, welcher auf eine unzulässige Masseverbindung hinweist.

2. Leistungsversorgungssystem (25) nach Anspruch 1, **dadurch gekennzeichnet, dass** eine Berechnungs- und Zuordnungseinrichtung (14) zur Ermittlung der erforderlichen bereitzustellenden Mindestbetriebsspannung für jede Stelleinrichtungen (2.1-2.n) vorgesehen ist.

3. Leistungsversorgungssystem (25) nach einem der Ansprüche 1 oder 2, **dadurch gekennzeichnet, dass** die Kennwertermittlungseinrichtung von einer der Getriebebaueinheit zugeordneten Steuereinrichtung (3) gebildet wird.

4. Leistungsversorgungssystem (25) nach einem der Ansprüche 1 bis 3, **dadurch gekennzeichnet, dass** jede Versorgungsleitung (5.1-2.n) mit einem eigenen Eingang der Kennwerterfassung- und Bestimmungseinrichtung gekoppelt ist.

5. Leistungsversorgungssystem (25) nach Anspruch 4, **dadurch gekennzeichnet, dass** die Mittel zur Erfassung des Stromes in Jeder Versorgungsleitung (5.1-5.n) in der Kennwertermittlungs- oder Bestimmungseinrichtung integriert sind.

6. Leistungsversorgungssystem (25) nach einem der Ansprüche 1 bis 5, **dadurch gekennzeichnet, dass** die Mittel zur Erfassung des Spannungsabfalles zwischen jeweils einer Versorgungsleitung (5,1-5.n) und der Masserückleitung (6) einen Spannungsteiler (8) umfassen.

7. Leistungsversorgungssystem (25) nach einem der Ansprüche 1 bis 6, **dadurch gekennzeichnet, dass** die Mittel zur Erfassung des Spannungsabfalles zwischen jeweils einer Versorgungsleitung (5.1-5,n) und der Masserückleitung (6) mit jeweils einem Eingang der Kennwertermittlungs- oder Bestimmungseinrichtung gekoppelt sind oder diese bilden.

8. Leistungsversorgungssystem (25) nach einem der Ansprüche 1 bis 7, **dadurch gekennzeichnet, dass** die Berechnungs- und Zuordnungseinrichtung (14) einen Summenstrombildner umfasst.

**9.** Leistungsversorgungssystem (25) nach einem der Ansprüche 1 bis 8, **dadurch gekennzeichnet, dass** die Berechnungs- und Zuordnungseinrichtung (14) eine Berechnungseinheit zur Berechnung des Widerstandes in der Masserückleitung (6) umfasst.

**10.** Leistungsversorgungssystem (25) nach einem der Ansprüche 1 bis 9, **dadurch gekennzeichnet, dass** die Berechnungs- und Zuordnungseinrichtung (14) eine Berechnungseinheit zur Ermittlung der Leistungslänge der Masserückleitung (6) aufweist.

**11.** Leistungsversorgungssystem (25) nach einem der Ansprüche 1 bis 10, **dadurch gekennzeichnet, dass** die Berechnungs- und Zuordnungseinrichtung eine Zuordnungseinheit der Länge der Versorgungsleitung (5.1-5.n) zur Länge der Masserückleitung (6) aufweist.

**12.** Leistungsversorgungssystem (25) nach einem der Ansprüche 1 bis 8, **dadurch gekennzeichnet, dass** die Berechnungs- und Zuordnungseinrichtung eine Berechnungseinheit zur Berechnung des Widerstandes in der Versorgungsleitung (5.1-5.n) umfasst.

**13.** Leistungsversorgungssystem (25) nach einem der Ansprüche 3 bis 8, **dadurch gekennzeichnet, dass** die Eingänge der Kennwertermittlungs- und Berechnungseinrichtung Eingänge der der Getriebebaueinheit (20) zugeordneten Steuereinrichtung (3) bilden.

**14.** Leistungsversorgungssystem (25) nach einem der Ansprüche 1 bis 13, **dadurch gekennzeichnet, dass** die Berechnungs- und Zuordnungseinrichtung (14) vom Microrechner gebildet wird.

**15.** Leistungsversorgungssystem (25) nach einem der Ansprüche 1 bis 14, **gekennzeichnet durch** die folgenden Merkmale:

die Kennwertermittlungseinrichtung bildet eine Diagnoseeinrichtung;
mit einem Speicher (16) zur Speicherung von Referenzwerten;
mit einer Vergleichseinrichtung (17) zum Vergleich aktuell ermittelter Größen mit Referenzwerten;
mit einem mit der Vergleichseinrichtung (17) gekoppelten Stellgrößenbildner für eine Fehlerinformation.

**16.** Leistungsversorgungssystem (25) nach Anspruch 15, **dadurch gekennzeichnet, dass** der Speicher (16), die Berechnungs- und Zuordnungseinrichtung (14) und die Vergleichseinrichtung (17) vom Microrechner gebildet werden.

**17.** Leistungsversorgungssystem (25) nach einem der Ansprüche 15 oder 16, **dadurch gekennzeichnet, dass** die Eingänge der Diagnoseeinrichtung vom Microrechner gebildet werden oder mit diesern verbunden sind.

**18.** Diagnoseverfahren für ein elektrisches Leistungsversorgungssystem (25), das gemäß einem der Ansprüche 1 bis 17 ausgeführt ist; **gekennzeichnet durch** die folgenden Schritte:

in zeitlichem Abstand wird wenigstens der Spannungsabfall In der Masserückleitung (6) ermittelt und aus wenigstens dem Spannungsabfall in der Masserückleitung (6) werden die Leitungswiderstände der einzelnen Versorgungsleitungen (5.1-5.N) und der Masserückleitung (6) ermittelt; und
die bei einer Erstermittlung ermittelten Werte für die Leitungswiderstände in den Versorgungsleitungen (5.1-5.n) und der Masserückleitung (6) werden als Referenzwerte gespeichert und jeweils mit den In zeitlichem Abstand ermittelten Werten für die Leitungswiderstände verglichen, wobei bei Überschreitung des Referenzwertes eine Fehlerinformation abgeleitet wird; wobei
die Ermittlung des Spannungsabfalls in der Masserückleitung (6) die folgenden Schritte umfasst:

Bestromung wenigstens einer ersten Stelleinrichtung (2.1-2.n) bei gleichzeitiger Nicht-Bestromung wenigstens einer zweiten Stelleinrichtung (2.1-2.n); und
Messung des Spannungsabfalles zwischen der Versorgungsleitung (5.1-5.n) der nicht bestromten Stelleinrichtungen (2.1-2.n) und der Masserückleitung (6).

**19.** Verfahren nach Anspruch 18, **dadurch gekennzeichnet, dass** zur Ermittlung des Leitungswiderstandes die Summe der Ströme zu den Stelleinrichtungen (2,9-2.n), insbesondere der Summenstrom in der Masserückleitung (6) ermittelt wird und der Leitungswiderstand als Funktion aus Spannungsabfall zwischen der Versorgungsleitung (5.1-5,n) der nicht bestromten Stelleinrichtungen (2.1-2.n) und der Masserückleitung (6) und dem Summenstrom ermittelt wird.

**20.** Verfahren nach Anspruch 19, **dadurch gekennzeichnet, dass** der Spannungsabfall über einer bestromten Versorgungsleitung (5.1-6.n) als Funktion des in der Versorgungsleitung (5,1-5.n) fließenden Einzelstromes und des Widerstandes der Masserückleitung (6) bestimmt wird.

**21.** Verfahren nach Anspruch 20, **gekennzeichnet**

**durch** die folgenden Merkmale:

bei Kenntnis des Leitungsquerschnittes der Masserückleitung (6) wird aus dem Leitungswiderstand die Länge der Masserückleitung (6) berechnet;

die Länge der Masserückleitung (6) wird unter Berücksichtigung eines vordefinierten Toleranzwertes der Länge der Versorgungsleitung (5.1-5.n) gleichgesetzt;

bei bekanntem Leitungsquerschnitt der Versorgungsleitung (5.1-5.n) wird der Leitungswiderstand der Versorgungsleitung (5.1-5.n) berechnet.

22. Verfahren nach Anspruch 21, **dadurch gekennzeichnet, dass** aus dem Einzelstrom in der Versorgungsleitung (5.1-5.n) und dem Leitungswiderstand der Spannungsabfall über der bestromten Versorgungsleitung (5.1-5.n) berechnet wird.

23. Verfahren nach Anspruch 22, **dadurch gekennzeichnet, dass** die erforderliche Mindestbetätigungspannung einer Stelleinrichtung (2.1-2.n) als Funktion der Summe aus dem Spannungsabfall über dieser einen Versorgungsleitung (5.1-5.n) bei Mindeststrom, dem Spannungsabfall über der Stelleinrichtung (2.1-2.n) und dem Abfall über der Masserückleitung (6) unter Berücksichtigung aller gleichzeitig betätigten Stelleinrichtungen (2.1-2.n) ermittelt wird.

24. Verfahren nach Anspruch 23, **dadurch gekennzeichnet, dass** die an der Spannungsquelle (22) bereitzustellende erforderliche Mindestspannung als Funktion der Summe aus den einzelnen Mindestbetätigungespannungen für alle gleichzeitig betätigten Stelleinrichtungen (2.1-2.n) gebildet wird.

25. Verfahren nach einem der Ansprüche 18 bis 24, **dadurch gekennzeichnet, dass** bei Abweichung der jeweiligen Leitungswiderstandswerte vom Referenzwert die Art der Fehlerinformation in Abhängigkeit von der Größe der Abweichung erzeugt wird.

26. Verfahren nach einem der Ansprüche 18 bis 25, **dadurch gekennzeichnet, dass** die Erfassung in fest vorgegebenen oder frei wählbaren oder vordefinierbaren Zeitintervallen erfolgt.

27. Verfahren nach einem der Ansprüche 18 bis 26, **dadurch gekennzeichnet, dass** jeder der nach Erstinbetriebnahme ermittelten Leitungswiderstände vor dem Vergleich mit dem Referenzwert um einen Korrekturwert, welcher das Widerstandsverhalten bei unterschiedlichen Temperaturen wiederspiegelt, korrigiert wird,

28. Verfahren nach Anspruch 27, **dadurch gekennzeichnet, dass** der Korrekturwert anhand der zum Zeitpunkt der zur Bestimmung der Leitungswiderstände erforderlichen Größen vorherrschenden Temperatur berechnet oder bestimmt wird.

29. Verfahren nach Anspruch 27, **dadurch gekennzeichnet, dass** lediglich ein Korrekturwert vorgegeben Ist und dieser einen Toleranzbereich definiert.

30. Verfahren nach einem der Ansprüche 18 bis 29, **dadurch gekennzeichnet, dass** bei Vergleich der Leitungswiderstände und dem Übersteigen eines vordefinierten Wertes durch die Abweichung die Fehlerinformation optisch oder akustisch angezeigt wird.

31. Verfahren nach einem der Ansprüche 18 bis 30, **dadurch gekennzeichnet, dass** bei Abweichung größer als ein vordefinierter Wert die den Stelleinrichtungen (2.1-2.n) in der Getriebeeinheit (20) zugeordneten Gangstufen gesperrt werden.

## Claims

1. An electrical power supply system (25) for adjustment devices (2.1-2.n) in drive units, in particular electromagnetically operatable actuators of a transmission unit;

with a switching arrangement (4),

the switching arrangement (4) including a voltage supply source (22);

the switching arrangement (4) comprising a supply line (5.1-5.n) associated with each electromagnetic adjustment device (2.1-2.n), which can be connected to the voltage supply source (22);

with means for detecting the current in each supply line (5.1-5.n); **characterised by** the following features:

a common ground return line (6) associated with all electromagnetic adjustment devices (2.1-2.n);

means for detecting the voltage drop systematically between a supply line (5.1-5.n) and the common ground return line (6);

a system for establishing characteristic values, including

a device for establishing and determining characteristic values and at least one microcontroller;

at least one calculation and assignment means (14) for determining the values mentioned below:

sum of the currents supplied to the energised adjustment devices (2,1-2.n); voltage drop in the ground return line (6);

line resistance in the ground return line (6);
length of the ground return line (6);
line resistance and voltage drop in the supply line (5.1-5.n);
and a switch (S1) arranged in the common ground return line (6), which is designed in such a way that a current flow or a voltage drop can be detected between the supply line (5.1-5.n) of the non-energised adjustment device (2.1-2.n) and the common ground return line (6) via the latter by opening the switch and simultaneous energisation of at least one first adjustment device (2.1-2.n) and simultaneous non-energisation of at least one second adjustment device (2.1-2.n), which points out to an inadmissible ground connection.

2. A power supply system (25) according to claim 1, **characterised in that** a calculation and assignment means (14) is provided for determining the necessary minimal operating voltage to be made available for each adjustment device (2.1-2.n).

3. A power supply system (25) according to one of the claims 1 or 2, **characterised in that** the device for establishing characteristic values consists of a control device (3) associated with the transmission unit.

4. A power supply system (25) according to one of the claims 1 to 3, **characterised in that** each supply line (5.1-2.n) is coupled to its own input of the device for establishing and determining characteristic values.

5. A power supply system (25) according to claim 4, **characterised in that** the means for detecting the current in each supply line (5.1-5.n) are integrated in the device for establishing or determining characteristic values.

6. A power supply system (25) according to one of the claims 1 to 5, **characterised in that** the means for detecting the voltage drop systematically between a supply line (5.1-5.n) and the common ground return line (6) include a voltage divider (8).

7. A power supply system (25) according to one of the claims 1 to 6, **characterised in that** the means for detecting the voltage drop systematically between a supply line (5.1-5.n) and the ground return line (6) are always coupled to an input of the device for establishing or determining characteristic values or form said device.

8. A power supply system (25) according to one of the claims 1 to 7, **characterised in that** the calculation and assignment means (14) contains a summation current generator.

9. A power supply system (25) according to one of the claims 1 to 8, **characterised in that** the calculation and assignment means (14) includes a calculation unit for calculating the resistance in the ground return line (6).

10. A power supply system (25) according to one of the claims 1 to 9, **characterised in that** the calculation and assignment means (14) includes a calculation unit for determining the power lengths of the ground return line (6).

11. A power supply system (25) according to one of the claims 1 to 10, **characterised in that** the calculation and assignment means includes an assignment unit of the length of the supply line (5.1-5.n) for the length of the ground return line (6).

12. A power supply system (25) according to one of the claims 1 to 8, **characterised in that** the calculation and assignment means includes a calculation unit for calculating the resistance in the supply line (5.1-5.n).

13. A power supply system (25) according to one of the claims 3 to 8, **characterised in that** the inputs of the device for establishing and calculating characteristic values form inputs of the control device (3) associated with the transmission unit (20).

14. A power supply system (25) according to one of the claims 1 to 13, **characterised in that** the calculation and assignment means (14) consists of the microcomputer.

15. A power supply system (25) according to one of the claims 1 to 14, **characterised by** the following features:

the device for establishing characteristic values constitutes a diagnosis device;
with a memory (16) for storing reference values;
with a comparison device (17) for comparing currently determined values with reference values;
with a correction variable generator coupled to the comparison device (17) for an error information.

16. A power supply system (25) according to claim 15, **characterised in that** the memory (16), the calculation and assignment means (14) and the comparison device (17) are provided by the microcomputer.

17. A power supply system (25) according to one of the claims 15 or 16, **characterised in that** the inputs of the diagnosis device are provided by the microcomputer or are connected thereto.

18. A diagnosis method for an electrical power supply system (25), which is

- designed according to one of the claims 1 to 17; **characterised by** the following steps:

at least the voltage drop in the ground return line (6) is determined in time interval and the resistivities of the various power line (5.1-5.n) and of the ground return line (6) are determined based at least on the voltage drop in the ground return line (6); and the values determined during a first determination process for the resistivities in the power lines (5.1-5.n) and the ground return line (6) are stored as reference values and systematically compared with the values established in time interval for the resistivities, whereas an error information is derived if the reference value is exceeded; wherein the determination of the voltage drop in the ground return line (6) includes the following steps:

energisation of at least one first adjustment device (2.1-2.n) with simultaneous non-energisation of at least one second adjustment device (2.1-2.n); and measurement of the voltage drop between the supply line (5.1-5.n) of the non-energised adjustment devices (2.1-2.n) and of the ground return line (6).

19. A method according to claim 18, **characterised in that** the sum of the currents supplied to the adjustment devices (2.1-2.n), in particular the summation current in the ground return line (6) is determined for establishing the resistivity and the resistivity is determined as a function of the voltage drop between the supply line (5.1-5.n) of the non-energised adjustment devices (2.1-2.n) and of the ground return line (6) and the summation current.

20. A method according to claim 19, **characterised in that** the voltage drop across an energised supply line (5.1-5.n) is determined as a function of the individual current flowing in the supply line (5.1-5.n) and of the resistance of the ground return line (6).

21. A method according to claim 20, **characterised by** the following features:

the length of the ground return line (6) is calculated based on the known line section of the ground return line (6) and from the line resistance; the length of the ground return line (6) is equated to the length of the supply line (5.1-5.n) while taking into account a preset tolerance value;
the resistivity of the supply line (5.1-5.n) is calculated based on the known line section of the supply line (5.1-5.n).

22. A method according to claim 21, **characterised in that** the voltage drop across the energised the supply line (5.1-5.n) is calculated from the individual current in the supply line (5.1-5.n) and the resistivity.

23. A method according to claim 22, **characterised in that** the required minimal actuation voltage of an adjustment device (2.1-2.n) is determined as a function of the sum from the voltage drop across said one supply line (5.1-5.n) in case of a minimal current, from the voltage drop across the adjustment device (2.1-2.n) and from the drop across the ground return line (6) while taking into account all simultaneously actuated adjustment devices (2.1-2.n).

24. A method according to claim 23, **characterised in that** the required minimal voltage to be made available on the voltage source (22) is determined as a function of the sum derived from the individual minimal actuation voltages for all simultaneously actuated adjustment devices (2.1-2.n).

25. A method according to any of the claims 18 to 24, **characterised in that** in case of deviation of the corresponding line resistance values from the reference value the kind of error information is generated depending on the magnitude of the deviation.

26. A method according to any of the claims 18 to 25, **characterised in that** the acquisition takes place in fixedly preset or freely selectable or presettable time intervals.

27. A method according to any of the claims 18 to 26, **characterised in that** each of the resistivities established after initial commissioning is corrected before comparison with the reference value by a correction value which reflects the resistance behaviour for different temperatures.

28. A method according to claim 27, **characterised in that** the correction value is calculated or determined using the temperature prevailing at the instant of the values necessary to determine the resistivities.

29. A method according to claim 27, **characterised in that** exclusively one correction value is preset and that said value defines a tolerance range.

**30.** A method according to any of the claims 18 to 29, **characterised in that** in case of comparison of the resistivities and of excess of a predefined value by the deviation, the error information is displayed optically or acoustically.

**31.** A method according to one of the claims 18 to 30, **characterised in that** in case of deviation greater than a predefined value, the gear ratios associated with the adjustment devices (2.1-2.n) in the transmission unit (20) are blocked.

## Revendications

**1.** Circuit d'alimentation électrique (25) pour dispositifs de réglage (2.1-2.n) dans des groupes d'entraînement, en particulier les organes de réglage à commande électromagnétique d'un ensemble de transmission;
disposant d'un agencement de circuit (4),
ledit agencement de circuit (4) comprenant une source d'alimentation en tension (22);
l'agencement de circuit (4) comprenant un ligne d'alimentation (5.1-5.n) associé à chaque dispositif de réglage électromagnétique (2.1-2.n), pouvant être raccordé à la source d'alimentation en tension (22);
de moyens permettant de détecter le courant dans chaque ligne d'alimentation (5.1-5.n);
présentant les caractéristiques suivantes:

un ligne commun de retour à la masse (6) associé à tous les dispositifs de réglage électromagnétiques (2.1-2.n);
de moyens permettant de détecter la chute de tension entre systématiquement un ligne d'alimentation (5.1-5.n) et le ligne commun de retour à la masse (6);
un système d'établissement de valeurs caractéristiques, comprenant un dispositif d'établissement et de détermination de valeurs caractéristiques et
au moins un microcontrôleur;
au moins un dispositif de calcul et d'agencement (14) permettant d'établir les valeurs mentionnées ci-dessous:

somme des courants injectés dans les dispositifs de réglage sous tension (2.1-2.n);
chute de tension dans le ligne de retour à la masse (6);
résistivité dans le ligne de retour à la masse (6);
longueur du ligne de retour à la masse (6);
résistivité et chute de tension dans le ligne d'alimentation (5.1-5.n); et

un interrupteur (S1) disposé dans le ligne commun de retour à la masse (6), conçu de telle sorte qu'un flux de courant ou une chute de tension entre le ligne d'alimentation (5.1-5.n) du dispositif de réglage non sous tension (2.1-2.n) et le ligne commun de retour à la masse (6) est détectable par le biais dudit interrupteur en cas d'ouverture de l'interrupteur et de mise sous tension simultanée d'au moins un premier dispositif de réglage (2.1-2.n) et mise hors tension simultanée au moins un second dispositif de réglage (2.1-2.n), qui renvoie à une liaison de masse inadmissible.

**2.** Circuit d'alimentation (25) selon la revendication 1, **caractérisé en ce qu'**un dispositif de calcul et d'agencement (14) est prévu pour établir la tension d'exploitation minimale nécessaire à fournir pour chaque dispositif de réglage (2.1-2.n).

**3.** Circuit d'alimentation (25) selon l'une des revendications 1 ou 2, **caractérisé en ce que** le dispositif d'établissement de valeurs caractéristiques est constitué d'un dispositif de commande (3) associé à l'ensemble de transmission.

**4.** Circuit d'alimentation (25) selon l'une quelconque des revendications 1 à 3, **caractérisé en ce que** chaque ligne d'alimentation (5.1-2.n) est couplé à une propre entrée du dispositif de détection et de détermination de valeurs caractéristiques.

**5.** Circuit d'alimentation (25) selon la revendication 4, **caractérisé en ce que** les moyens de détection du courant dans chaque ligne d'alimentation (5.1-5.n) sont intégrés au dispositif d'établissement ou de détermination de valeurs caractéristiques

**6.** Circuit d'alimentation (25) selon l'une des revendications 1 à 5, **caractérisé en ce que** les moyens permettant de détecter la chute de tension entre systématiquement un ligne d'alimentation (5.1-5.n) et le ligne commun de retour à la masse (6) comprennent un diviseur de tension (8).

**7.** Circuit d'alimentation (25) selon l'une des revendications 1 à 6, **caractérisé en ce que** les moyens permettant de détecter la chute de tension entre systématiquement un ligne d'alimentation (5.1-5.n) et le ligne commun de retour à la masse (6) sont systématiquement couplés à une entrée du dispositif d'établissement ou de détermination de valeurs caractéristiques ou bien constituent ce dernier.

**8.** Circuit d'alimentation (25) selon l'une quelconque des revendications 1 à 7, **caractérisé en ce que** le dispositif de calcul et d'agencement (14) comprend un générateur de courant de sommation.

**9.** Circuit d'alimentation (25) selon l'une des revendications 1 à 8, **caractérisé en ce que** le dispositif de calcul et d'agencement (14) comprend une unité de calcul permettant de calculer la résistance dans le ligne de retour à la masse (6).

**10.** Circuit d'alimentation (25) selon l'une des revendications 1 à 9, **caractérisé en ce que** le dispositif de calcul et d'agencement (14) comprend une unité de calcul permettant d'établir la longueur d'alimentation du ligne de retour à la masse (6).

**11.** Circuit d'alimentation (25) selon l'une des revendications 1 à 10, **caractérisé en ce que** le dispositif de calcul et d'agencement comprend une unité d'agencement de la longueur du ligne d'alimentation (5.1-5.n) en fonction de la longueur du ligne de retour à la masse (6).

**12.** Circuit d'alimentation (25) selon l'une des revendications 1 à 8, **caractérisé en ce que** le dispositif de calcul et d'agencement comprend une unité de calcul permettant de calculer la résistance dans le ligne d'alimentation (5.1-5.n).

**13.** Circuit d'alimentation (25) selon l'une quelconque des revendications 3 à 8, **caractérisé en ce que** les entrées du dispositif d'établissement et de calcul de valeurs caractéristiques constituent les entrées du dispositif de commande (3) associé à l'ensemble de transmission (20).

**14.** Circuit d'alimentation (25) selon l'une quelconque des revendications 1 à 13, **caractérisé en ce que** le dispositif de calcul et d'agencement (14) est constitué d'un micro-ordinateur.

**15.** Circuit d'alimentation (25) selon l'une des revendications 1 à 14, présentant les caractéristiques suivantes:

le dispositif d'établissement de valeurs caractéristiques constitue un dispositif de diagnostic;
pourvu d'une mémoire (16) permettant le stockage de valeurs de référence;
disposant d'un dispositif comparateur (17) permettant la comparaison de valeurs courantes obtenues avec des valeurs de référence;
d'un générateur de valeurs caractéristiques couplé au dispositif comparateur (17) pour afficher une information d'erreur.

**16.** Circuit d'alimentation (25) selon la revendication 15, **caractérisé en ce que** la mémoire (16), le dispositif de calcul et d'agencement (14) et le dispositif comparateur (17) sont constitués par le micro-ordinateur.

**17.** Circuit d'alimentation (25) selon l'une des revendications 15 ou 16, **caractérisé en ce que** les entrées du dispositif de diagnostic sont constituées par le micro-ordinateur ou bien sont reliées à celui-ci.

**18.** Procédé de diagnostic pour circuit d'alimentation électrique (25), conçu selon l'une des revendications 1 à 17, présentant les phases suivantes:

à intervalle de temps régulier, on détermine au moins la chute de tension dans le ligne de retour à la masse (6) et l'on détermine la résistivité des divers lignes d'alimentation (5.1-5.n) et du ligne de retour à la masse (6) au moins à partir de la chute de tension dans le ligne de retour à la masse (6); et
les valeurs obtenues lors d'une première détermination concernant la résistivité des lignes d'alimentation (5.1-5.n) et du ligne de retour à la masse (6) sont stockés en mémoire comme valeurs de référence avant de les comparer systématiquement aux valeurs obtenues à intervalle de temps régulier en matière de résistivité, tandis que l'on déduit une information d'erreur en cas de dépassement de la valeur de référence;
dans lequel la détermination de la chute de tension dans le ligne de retour à la masse (6) comprend les phases suivantes:

mise sous tension au moins d'un premier dispositif de réglage (2.1-2.n) avec mise hors tension simultanée d'au moins un second dispositif de réglage (2.1-2.n); et
mesure de la chute de tension entre le ligne d'alimentation (5.1-5.n) des dispositifs de réglage non sous tension (2.1-2.n) et du ligne de retour à la masse (6).

**19.** Procédé selon la revendication 18 **caractérisé en ce que** pour établir la résistivité, on détermine la somme des courants injectés dans les dispositifs de réglage (2.1-2.n), en particulier le courant de sommation dans le ligne de retour à la masse (6) de même la résistivité en fonction de la chute de tension entre le ligne d'alimentation (5.1-5.n) des dispositifs de réglage non sous tension (2.1-2.n) et du ligne de retour à la masse (6) et du courant de sommation.

**20.** Procédé selon la revendication 19 **caractérisé en ce que** l'on définit la chute de tension de part et d'autre d'un ligne d'alimentation sous tension (5.1-5.n) en fonction du courant individuel passant dans le ligne d'alimentation (5.1-5.n) et de la résistance du ligne de retour à la masse (6).

**21.** Procédé selon la revendication 20, présentant les caractéristiques suivantes:

on calcule la longueur du ligne de retour à la masse (6) à partir de la résistivité et sur la base de la section du ligne de retour à la masse (6); on affecte la même valeur à la longueur du ligne d'alimentation (5.1-5.n) que celle du ligne de retour à la masse (6) en tenant compte d'une valeur de tolérance prédéfinie; on calcule la résistivité du ligne d'alimentation (5.1-5.n) sur la base de la section du ligne d'alimentation (5.1-5.n).

22. Procédé selon la revendication 21 **caractérisé en ce que** l'on calcule la chute de tension de part et d'autre du ligne d'alimentation sous tension (5.1-5.n) à partir du courant individuel passant dans le ligne d'alimentation (5.1-5.) et de la résistivité.

23. Procédé selon la revendication 22 **caractérisé en ce que** l'on détermine la tension de commande minimale requise d'un dispositif de réglage (2.1-2.n) en fonction de la somme de la chute de tension de part et d'autre dudit ligne d'alimentation (5.1-5.n) en présence de courant minimal, de la chute de tension de part et d'autre du dispositif de réglage (2.1-2.n) et de la chute de part et d'autre du ligne de retour à la masse (6) en tenant compte de tous les dispositifs de réglage sollicités simultanément (2.1-2.n).

24. Procédé selon la revendication 23, **caractérisé en ce que** la tension minimale requise à fournir au niveau de la source de tension (22) est fonction de la somme des diverses tensions de commande minimales pour tous les dispositifs de réglage sollicités simultanément (2.1-2.n).

25. Procédé selon l'une des revendications 18 à 24, **caractérisé en ce que**, en présence d'un écart des diverses résistivités par rapport à la valeur de référence, le type d'information d'erreur est généré en fonction de l'ampleur dudit écart.

26. Procédé selon l'une des revendications 18 à 25, **caractérisé en ce que** la détection se déroule à intervalles de temps strictement prédéterminés ou librement éligibles ou encore prédéfinissables.

27. Procédé selon l'une des revendications 18 à 26, **caractérisé en ce que** l'on corrige chacune des résistivités établies après la première mise en service avant de les comparer à la valeur de référence, à un degré reflétant le comportement de résistance à différentes températures.

28. Procédé selon la revendication 27, **caractérisé en ce que** l'on calcule ou définit la valeur de correction en fonction de la température en présence des valeurs nécessaires à la détermination des résistivités.

29. Procédé selon la revendication 27, **caractérisé en ce que** seule une valeur de correction est prédéfini et que celle-ci définit une plage de tolérance.

30. Procédé selon l'une des revendications 18 à 29, **caractérisé en ce que** l'information d'erreur est affichée optiquement ou acoustiquement en cas de comparaison des résistivités et de dépassement d'une valeur prédéfinie provoqué par l'écart.

31. Procédé selon l'une des revendications 18 à 30, **caractérisé en ce que** les rapports d'engrenage associés aux dispositifs de réglage (2.1-2.n) dans l'unité de transmission (20) sont bloqués en présence d'un écart supérieur à une valeur prédéfinie.

Fig.1

**Fig.2**

Start

$R_{LMasse} = f(U_{LMasse}, I_{LMasse})$
$R_{LVn} = f(U_{LVn}, I_{LVn})$

Bestromung von Stelleinrichtung 2n+1 mit $I_{n+1}$
Nichtbestromung von 2n

$U_{LMasse} = U_n$

$\sum I_n = I_{Summe}$

$R_{LMasse} = \dfrac{U_{LMasse}}{I_{LMasse}}$

if $R_{LMasse-referenz}$ vorhanden — nein → $R_{LMasse} = R_{LMasse-referenz}$

ja

$f_{LMasse} = f(R_{LMasse}, A_{LMasse})$

$f_{LMasse} \approx f_{LVn}$

$R_{LVn} = f(U_{LVn}, I_{LVn})$

if $R_{LVn-referenz}$ vorhanden — nein → $R_{LVn} = R_{LV-referenz}$

ja

$R_{LVn} \gtrless R_{LV-referenz}$ — ja

$R_{LMasse} \gtrless R_{LMasse-referenz}$ — ja

$U_B = f(U_{LMasse}, U_{LVn}, U_{LMVn})$

Fehler

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19745175 A1
- DE 4134056 A1
- US 5909348 A